# EUROPEAN PATENT APPLICATION

(11) **EP 2 416 338 A1**
(43) Date of publication of application: **08.02.2012**
(21) Application number: 10758222.3
(22) Date of filing: 25.03.2010
(51) Int. Cl.: H01H 36/00, G06F 3/041, G06F 3/044, H01H 11/00

(54) **CAPACITANCE TYPE TOUCH MEMBER AND METHOD FOR PRODUCING THE SAME, AND CAPACITANCE TYPE TOUCH DETECTION DEVICE**

(30) Priority: 03.04.2009 JP 2009090694
(71) Applicant: Sony Corporation, Tokyo 108-0075 (JP)
(72) Inventor: ENOKI, Osamu, Tokyo 108-0075 (JP)
(74) Representative: Müller - Hoffmann & Partner
(86) International application number: PCT/JP2010/002110
(87) International publication number: WO 2010/113437

(57) **Abstract**

[Object] To provide a capacitive touch member having a flexible shape or a stereoscopic shape and includes a light transmissive detection electrode, a manufacturing method therefor, and a capacitive touch detection apparatus including the capacitive touch member.

[Solving Means] Produced is a capacitive touch member (10) including a film-like or plate-like support (1) that is formed of an insulating material and has a flexible shape or a stereoscopic shape, a detection electrode (2) that is arranged on at least a part of one surface of the support (1) and formed of a light transmissive conductive layer containing a carbon nano linear structure such as a carbon nanotube, and a lead-out wire (3) that is led out from the detection electrode (2). A capacitive touch detection apparatus is constituted of the touch member (10) and a capacitance detection circuit (60) that is electrically connected to the detection electrode (2) via the lead-out wire (3) and detects a change in capacitance due to approach or contact of a human body with respect to a touch surface (4). The detection electrode (2) may be coated with a protective film, and a surface of the protective film may be used as a touch surface.

## Description

### Technical Field

The present invention relates to a capacitive touch member having a flexible shape or a stereoscopic shape, a manufacturing method therefor, and a capacitive touch detection apparatus including the capacitive touch member.

### Background Art

As input apparatuses for electronic equipment, touch panels are used in various fields. The touch panel is constituted of a touch member having a touch surface approached or contacted by a contact object such as a part of a human body, e.g., a finger or a pen tip, a control circuit unit that generates an electrical signal corresponding to a touch position on the touch surface that is designated by the approach or contact, and the like. In many cases, the touch panel is configured such that the touch member is arranged in front of an image display apparatus and a user determines a touch position based on a display image transmitted through a touch surface. In this case, the touch member needs to be light transmissive such that a display image of the image display apparatus is transmitted therethrough.

Various systems have been developed for touch panels. Among them, a capacitive touch panel is constituted of a touch member including a detection electrode that senses the approach or contact of a contact object such as a part of a human body, e.g., a finger with respect to a touch surface, a detection circuit unit that detects a change in capacitance between the contact object and the detection electrode, which is caused by the approach or contact, and generates an electrical signal corresponding to a touch position, and the like. As described above, in the case where the touch member is arranged in front of the image display apparatus, the detection electrode needs to be light transmissive.

The capacitive touch panel has excellent features of being advantageous in reduction in weight and improvement in light transparency because of a simple structure of the touch member, high durability because of an absence of a moving part, the capability of multi-point input, and the like. Therefore, the capacitive touch panel is expected to become more widespread hereafter.

A touch panel currently put into practical use is substantially limited to a flat panel having a flat touch surface. However, in a three-dimensional image display apparatus, on-vehicle electronic equipment, game equipment, or the like, a touch panel having a curved touch surface (hereinafter, referred to as curved touch panel) is requested in order to improve the operability of equipment. In this regard, Patent Document 1 described below proposes a display apparatus including a capacitive touch panel having a curved touch surface and an image projection unit that projects an image on a back surface of the touch panel.

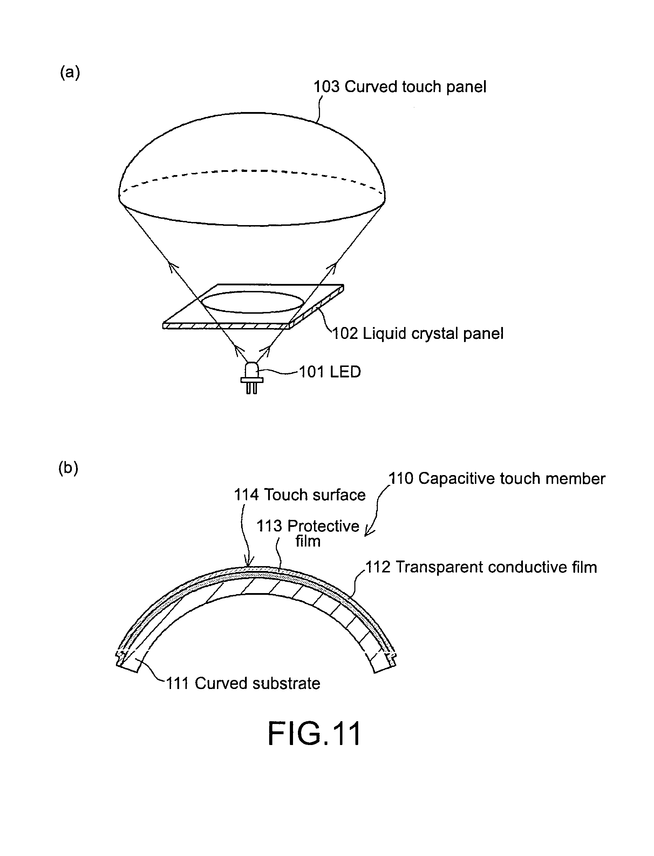

Fig. 11(a) is a perspective view showing a structure of a display apparatus 100 equipped with a touch panel shown in Patent Document 1. The display apparatus 100 includes a light-emitting diode (LED) 101, a liquid crystal panel 102, and a curved touch panel 103. The liquid crystal panel 102 is a transmissive liquid crystal panel, and light emitted from the LED 101 is passed through the liquid crystal panel 102 to reach the curved touch panel 103. The LED 101 and the liquid crystal panel 102 are constituted as an image projection unit that projects a display image on a back surface of the curved touch panel 103 based on a video signal supplied from a driver circuit (not shown). A light-scattering layer is provided on the back surface of the curved touch panel 103, and light that has reached the light-scattering layer is scattered so that a display image is formed on the back surface of the curved touch panel 103.

Fig. 11(b) is a cross-sectional view showing a structure of a capacitive touch member 110 of the curved touch panel 103 (it should be noted that the light-scattering layer on the back surface is not shown). The touch member 110 is formed by laminating, on a curved substrate 111 formed into a convex shape, a transparent conductive film 112 and a protective film 113 in the stated order. The curved substrate 111 is, for example, a glass substrate or a transparent resin substrate having a thickness of about 1 to 2 mm. The transparent conductive film 112 is formed of, for example, indium tin oxide (ITO) and is formed on the curved substrate 111 by a sputtering method or the like. The protective film 113 is formed of, for example, an insulating material such as silicon oxide, silicon nitride, or a transparent resin and is formed on the transparent conductive film 112 by a sputtering method, a CVD (chemical vapor deposition) method, a coating method, or the like. In the touch member 110, the surface of the protective film 113 laminated on the transparent conductive film 112 is used as a touch surface 114. On a surface (back surface) 115 of the curved substrate 111 on the opposite side of the touch surface 114, the light-scattering layer (not shown) is arranged.

The curved touch panel 103 is constituted as a capacitive touch panel and the transparent conductive film 112 functions as a detection electrode. Though not shown in the figure, the transparent conductive film 112 is connected to a detection circuit unit by a plurality of lead wires. When the contact object such as a finger approaches or contacts the touch surface 114 of the touch member 110, current flowing in the lead wires is changed due to capacitance generated between the contact object and the transparent conductive film 112. Based on this current, a two-dimensional touch position on the touch surface 114 is calculated by the detection circuit unit, and an electrical signal corresponding to the touch position is output. To precisely calculate the two-dimensional touch position, three or more lead wires are required to be provided at an outer circumferential portion of the transparent conductive film 112.

There is described in Patent Document 1 that the touch panel has a resistive system, an electromagnetic induction system, an optical system, an ultrasonic system, and the like in addition to the capacitive system, but the systems other than the capacitive system are not suitable for the curved touch panel. The following reasons are described therein.

In the resistive system, it is necessary to hold two substrates on which resistive films are formed with a slight gap therebetween. In the case where the shape of the substrate is a spherical surface or an arbitrary curved surface, it is extremely difficult to adjust the gap between the two substrates to a target value with high accuracy. In the electromagnetic induction system, an opaque sensor substrate is required to be arranged on a back surface of a display element. When the sensor substrate is arranged at the position as described above, sensor sensitivity is lowered.
In addition, it is difficult to determine when to judge a touch based on a degree of approach of a pen. In the optical system, it is impossible to detect a touch along a curved surface in principle due to light traveling in a straight line. In the ultrasonic system, it is difficult to form a minute ultrasonic transducer (transmission/reception element) on a curved surface in terms of manufacturing. Unlike those four systems, in the capacitive system, even if the curved substrate 111 has any curved shape, a smaller number of problems in manufacturing are caused.

Further, Patent Document 2 described below proposes a resistive touch panel characterized in a touch surface having a curved shape. The touch panel is constituted of an upper film substrate and a lower film substrate, and the film substrates are each formed of a transparent plastic film on which a transparent conductive polymer film, an electrode, and a wiring pattern are formed.

Further, Patent Document 3 described below proposes an organic conductive polymer composition characterized by including at least a polythiophene derivative polymer, a water-soluble organic compound (excluding nitrogen-containing organic compound), and a dopant, a transparent conductor formed using the composition, and an input apparatus including the transparent conductor. There is described that the input apparatus can be a resistive touch panel-type input apparatus in which a transparent conductor is arranged in a curved shape.

Now, as a light transmissive conductive material constituting the touch panel, there is proposed the use of a carbon nanotube in addition to the oxide-based transparent conductive material such as ITO or conductive polymer described above. For example, Patent Document 4 described below proposes a method of manufacturing a conductive film in which carbon nanotubes are dispersed or embedded as layers only in a surface portion of a resin film by dispersing and arranging carbon nanotubes by growth on a substrate surface, plating, dispersion, or casting of carbon nanotubes dispersion liquid, forming a resin film thereon, and then separating the formed resin film, and also proposes a flexible resistive touch panel using the conductive film.

Further, Patent Document 5 described below proposes a transparent conductive film that is coated with carbon nanotubes over 50% or more of the area of at least one surface of a transparent base material by applying carbon nanotube dispersion liquid by a coating method such as roll coating, and meets the following condition of transparency with respect to light having a wavelength of 550 nm:
Light transmittance of transparent conductive film/light transmittance of transparent base material>0.85.
There is described that this can be used as a transparent conductive film for a touch panel, or the like.

On the other hand, unlike the touch panel, Patent Document 6 described below shows an example of a capacitive touch sensor that senses approach or contact of a contact object such as a human body. Fig. 12(a) is a perspective view showing an arrangement example of a touch sensor 200 shown in Patent Document 6, and Fig. 12(b) is a cross-sectional view taken at a position indicated by the line 12b-12b of the perspective view (a).

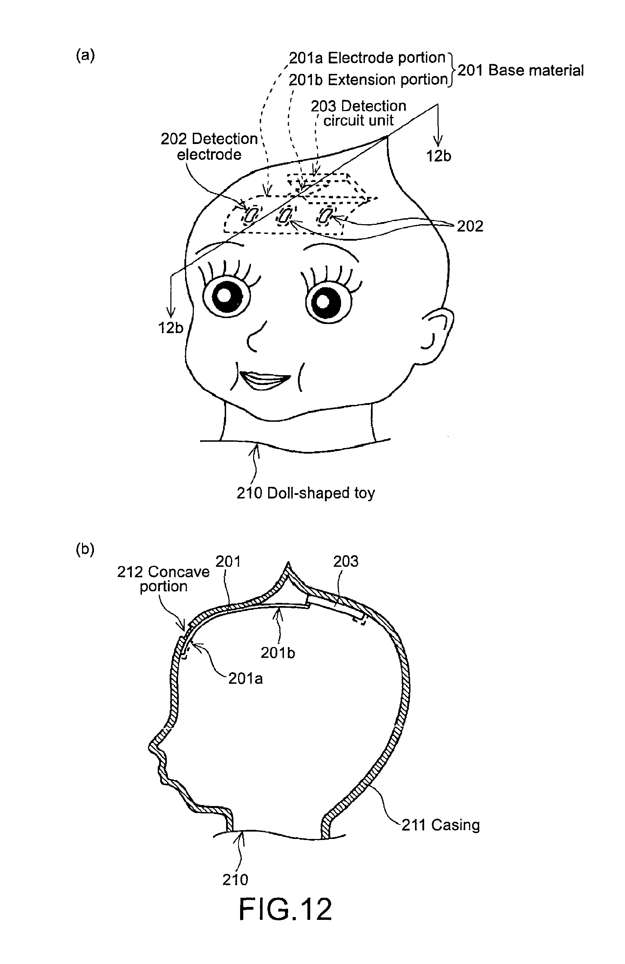

As shown in Fig. 12(a), the touch sensor 200 is arranged in, for example, electronic equipment such as a doll-shaped toy 210 over a front head part to a rear part of the top of the head. As shown in Fig. 12(b), the touch sensor 200 is constituted of a base material 201, detection electrodes 202 formed in an electrode portion 201a thereof, wires (not shown) formed in an extension portion 201b thereof, and a detection circuit unit 203.

The base material 201 is an insulating sheet or the like that is formed of a resin material having flexibility. The base material 201 is constituted of the electrode portion 201a formed to have a predetermined dimension and the extension portion 201b extending from an end portion of the electrode portion 201a toward the detection circuit unit 203, and on surfaces thereof, the electrodes 202 and the wires are arranged. The detection electrodes 202 and the wires are formed of, for example, a conductive material such as copper, and are formed by, for example, a known method such as a vapor deposition method or a plating method. Alternatively, a known method of printing a conductive coating such as a silver paste may be used for the formation. The detection circuit unit 203 is a signal processing means for detecting a change in capacitance between a contact object and the detection electrode 202.

The touch sensor 200 is fixed to an inner curved surface of a casing 211 forming an outer shape of the doll-shaped toy 210. The casing 211 is preferably formed of a material that is other than metal and has a large dielectric constant, for example, a synthetic resin. There is described that the electronic equipment incorporating the touch sensor 200 is, for example, a PDA (Personal Digital Assistant), a mobile phone, or a video camera, in addition to the doll-shaped toy 210.

It should be noted that Patent Document 2 describes that the electrode 202 cannot be seen from the outside, and therefore when a concave portion 212 is provided at a position of the casing 211 that is opposed to the electrode 202 to clarify the position of the electrode 202, unintended contact by a human body of a user or another contact object can be suppressed easily and malfunction can be reduced, which is preferable.

Patent Document 1: Japanese Patent Application Laid-open No. 2007-279819 (pages 4 and 5, Figs. 1 and 3)
Patent Document 2: Japanese Patent Application Laid-open No. 2008-47026 (pages 4 and 5, Figs. 1 and 2)
Patent Document 3: WO2004/106404 (pages 6 to 11, Fig. 1)
Patent Document 4: WO2006/030981 (claims 1, 2, 22, and 23, pages 6 to 9 and 11, Fig. 14)
Patent Document 5: Japanese Patent Application Laid-open No. 2008-177143 (claims 7 and 9 to 14, pages 9, 11 to 13, 15, and 16, Fig. 1)
Patent Document 6: Japanese Patent Application Laid-open No. 2005-339856 (pages 4 to 6 and 8, Figs. 1 and 5)

### Disclosure of the Invention

### Problem to be solved by the Invention

As described above, in consideration of the case where a touch member is arranged in front of an image display apparatus, the detection electrode constituting the capacitive touch panel is desired to be light transmissive.

A transparent conductive material widely used currently is indium tin oxide (ITO), fluorine-doped tin oxide (FTO), or the like. Those oxide-based transparent conductive materials are generally formed on a light transmissive support formed of glass, polyethylene terephthalate (PET), or the like by a physical vapor deposition method (PVD) such as a vacuum vapor deposition method or a sputtering method. In PVD, deposition on a flat surface is easily performed, but uniform deposition on a stereoscopic object such as a curved surface is extremely difficult. In recent years, a transparent conductive material has been capable of being formed on a curved substrate by a plasma CVD method (see WO2006/033268). This method requires a large-scale apparatus for the generation of plasma and the control of conditions. Further, an oxide-based transparent conductive material such as ITO or FTO is fragile and causes minute cracks when a stress is applied thereto, and conductivity is abruptly lowered (see Japanese Patent Application Laid-open No. 2008-36902). Therefore, forming processing such as bending cannot be performed after the deposition.

In Patent Documents 2 and 3, a conductive polymer is used as a transparent conductive material. The conductive polymer is excellent in formability, but it is inferior to ITO or the like in conductivity and transparency and therefore predetermined conductivity is not obtained, which may be a cause of malfunction of a touch panel. Further, the conductive polymer is also inferior in durability and has a problem of operation characteristics under a high temperature environment, particularly in a vehicle. Further, the touch panels intended in Patent Documents 2 and 3 are resistive touch panels. As described above, in the resistive touch panel, it is necessary to hold two base materials on which resistive films are formed with a slight gap therebetween. In the case where the shape of the base material is a spherical surface or an arbitrary curved surface, it is extremely difficult to adjust the gap between the two base materials to a target value with high accuracy.

In Patent Documents 4 and 5, a carbon nanotube is used as a transparent conductive material. However, similar to Patent Documents 2 and 3, the touch panels intended in Patent Documents 4 and 5 are resistive touch panels, and in the case where the shape of the base material is a spherical surface or an arbitrary curved surface, it is extremely difficult to adjust the gap between the two base materials to a target value with high accuracy.

For the reasons described above, the touch panel currently put into practical use is substantially limited to a flat panel having a flat touch surface.

On the other hand, in the touch sensor proposed in Patent Document 6, the detection electrode 202 is provided on an inner wall of the casing 211. Accordingly, the detection electrode 202 does not have to be light transmissive, but it has to be flexible. In addition, if the detection electrode is transparent, the detection electrode can be provided on an outer wall of the casing 211 without impairing the outer appearance. In this case, compared to the case of being provided inside the casing 211, the detection electrode can be provided much easier. Further, to many articles that are difficult to incorporate the detection electrode 202, the detection electrode can also be provided to impart a touch sensor function.

In view of the circumstances as described above, it is an object of the present invention to provide a capacitive touch member having a flexible shape or a stereoscopic shape and including a light transmissive detection electrode, a manufacturing method therefor, and a capacitive touch detection apparatus including the capacitive touch member. Means for solving the Problem

In other words, the present invention relates to a first capacitive touch member including:
a film-like or plate-like support that is formed of an insulating material and has a flexible shape or a stereoscopic shape;
a detection electrode that is arranged on at least a part of one surface of the support and is formed of a light transmissive conductive layer containing a carbon nano linear structure; and
a lead-out wire that is led out from the detection electrode, in which
a surface of the support that is opposite to the surface on which the detection electrode is arranged is used as a touch surface, and approach or contact of a contact object with respect to the touch surface is sensed as a change in capacitance between the contact object and the detection electrode.

Further, the present invention relates to a second capacitive touch member including:
a film-like or plate-like support that is formed of an insulating material and has a flexible shape or a stereoscopic shape;
a detection electrode that is arranged on at least a part of one surface of the support and is formed of a light transmissive conductive layer containing a carbon nano linear structure;
a protective film to coat the detection electrode; and
a lead-out wire that is led out from the detection electrode, in which
a surface of the protective film is used as a touch surface, and approach or contact of a contact object with respect to the touch surface is sensed as a change in capacitance between the contact object and the detection electrode.

Further, the present invention relates to a third capacitive touch member including:
a film-like or plate-like support that is formed of an insulating material and has a flexible shape or a stereoscopic shape;
a first detection electrode that is arranged on at least a part of one surface of the support and is formed of a light transmissive conductive layer containing a carbon nano linear structure;
a first protective film to coat the detection electrode;
a second detection electrode that is arranged on at least a part of a surface opposite to the surface of the support and is formed of a light transmissive conductive layer containing a carbon nano linear structure;
a second protective film to coat the detection electrode; and
lead-out wires that are led out from the first detection electrode and the second detection electrode, in which
a surface of the first protective film and/or the second protective film is used as a touch surface, and contact or approach of a contact object with respect to the touch surface is sensed as a change in capacitance between the contact object and the first detection electrode and/or the second detection electrode.

Further, the present invention relates to a fourth capacitive touch member including:
a detection electrode that is arranged on at least a part of a surface of an article and is formed of a light transmissive conductive layer containing a carbon nano linear structure;
a protective film to coat the detection electrode; and
a lead-out wire that is led out from the detection electrode, in which
a surface of the protective film is used as a touch surface, and approach or contact of a contact object with respect to the touch surface is sensed as a change in capacitance between the contact object and the detection electrode.

Further, the present invention relates to a capacitive touch detection apparatus including:
any one of the first to fourth capacitive touch members;
a detection circuit unit that is electrically connected to the detection electrode via the lead-out wire and detects the change in capacitance due to the approach or contact of the contact object with respect to the touch surface.

Further, the present invention relates to a method of manufacturing a capacitive touch member, including:
preparing dispersion liquid obtained by dispersing carbon nano linear structures in a dispersion solvent containing a dispersing agent;
performing at predetermined times a series of steps of causing the dispersion liquid to adhere to a surface of a film-like or plate-like support that is formed of an insulating material and has a flexible shape or a stereoscopic shape, or to a surface of an article to which a touch member is provided,
evaporating the dispersion solvent and firmly fixing the carbon nano linear structures to the surface of the support or the surface of the article,
washing the surface of the support or the surface of the article by a washing solvent and removing the dispersing agent, and
evaporating the washing solvent, and
forming a detection electrode formed of a light transmissive conductive layer containing the carbon nano linear structures on the surface of the support or the surface of the article; and
providing a lead-out wire to the detection electrode.

It should be noted that in the present invention, a carbon nano linear structure is typically a single-layer carbon nanotube or a multiplayer carbon nanotube having two or more layers, but it is assumed to include a material having crystallinity (regularity of atomic arrangement) that is not so high as that of a carbon nanotube. In other words, the carbon nano linear structure may be any structure as long as it is formed of a carbon-based material that includes all or a part of a cylindrically rolled graphene sheet structure as a conductive area, the graphene sheet structure having an outer shape of an extra-fine line whose size in cross section is about several nm to several ten nm, the movement of electrons in a cross-sectional direction is limited in a nanoscale area, and only the movement of electrons in a longitudinal direction (axial direction) is permitted in macro scale. The outer shape thereof may be linear or curved and include branches or joints. Specifically, in addition to the cylinder-shaped carbon nanotube, cup-stacked carbon nanotubes, carbon nanohorns, carbon nanobamboos, vapor-grown carbon nanofibers (for example, VGCF manufactured by SHOWA DENKO K. K.), carbon nano wires, or the like may be possible.

### Effect of the Invention

The feature of the capacitive touch member and capacitive touch detection apparatus of the present invention resides in that a practical touch detection apparatus having a flexible shape or a stereoscopic shape has been achieved for the first time by using a light transmissive conductive layer containing a carbon nano linear structure as a detection electrode and combining the light transmissive conductive layer with a capacitive touch detection method.

The carbon nano linear structure has a diameter much smaller than a wavelength of visible light, and therefore causes visible light to pass therethrough well. In addition, some carbon nano linear structures have extremely high electrical conductivity like a metallic carbon nanotube, and show sufficient electrical conductivity at a small surface density. In addition, unlike an oxide-based transparent conductive material such as ITO, a carbon nanotube has supple and strong mechanical characteristics. Further, a carbon nanotube is chemically stable. As described above, a light transmissive conductive layer containing the carbon nano linear structure has the best characteristics as a detection electrode used for a touch member having a flexible shape or a stereoscopic shape.

As described with reference to Figs. 11 and 12, in a capacitive touch detection method, one detection electrode can be caused to function as a touch member, which can extremely simplify the structure of the touch member. This is an extremely great advantage as compared to a resistive touch panel in which it is necessary to hold two base materials on which resistive films are formed with a slight gap therebetween. The present invention has been completed on a deep awareness that a capacitive touch detection method is a unique system by which a practical touch detection apparatus having a flexible shape or a stereoscopic shape can be achieved.

A method of manufacturing a capacitive touch member according to the present invention includes
performing at predetermined times a series of steps of causing the dispersion liquid to adhere to a surface of a film-like or plate-like support that is formed of an insulating material and has a flexible shape or a stereoscopic shape, or to a surface of an article to which a touch member is provided,
evaporating the dispersion solvent and firmly fixing the carbon nano linear structures to the surface of the support or the surface of the article,
washing the surface of the support or the surface of the article by a washing solvent and removing the dispersing agent, and
evaporating the washing solvent, and
forming a detection electrode formed of a light transmissive conductive layer containing the carbon nano linear structures on the surface of the support or the surface of the article.

The feature of the manufacturing method resides in that after the dispersion solvent is evaporated and the carbon nano linear structures are firmly fixed to the surface of the support or the surface of the article, the surface of the support or the surface of the article is washed by the washing solvent, the dispersing agent is removed, and then the washing solvent is evaporated. Since the dispersing agent interposed between the carbon nano linear structures is removed in the washing process by the washing solvent, the adhesiveness between the carbon nano linear structures is improved and the conductivity is improved. Since most of the carbon nano linear structures are firmly fixed to the surface of the support or the surface of the article in the previous process of evaporating the dispersion solvent, those carbon nano linear structures do not fall off in the washing process. Further, a small number of carbon nano linear structures in the poor fixed state are removed in the washing process. The remaining carbon nano linear structures are more firmly fixed to the surface of the support or the surface of the article in the process of evaporating the washing solvent. As described above, the quality of the transparent conductive layer is improved.

Further, in this manufacturing method, a series of deposition processes described above from the adhesion of the dispersion liquid to the evaporation of the washing solvent is repeatedly performed until a deposition layer of the carbon nano linear structures reaches a predetermined thickness and necessary conductivity is obtained. Therefore, the concentration of carbon nanotubes in the dispersion liquid can be suppressed to be low as compared to a method of forming a deposition layer having a predetermined thickness by a single deposition process. As a result, a deposition layer having high uniformity can be formed and a conductive layer having uniform conductivity can be obtained.

As described above, in the method of manufacturing a capacitive touch member of the present invention, it is possible to form a deposition layer having a small amount of dispersing agent or impurities, having uniform distribution of carbon nano linear structures, and having high flatness by a simple and easily scaled-up method, and to produce a light transmissive conductive layer capable of being expressed without impairing the light transparency, electrical conductivity characteristics, and mechanical characteristics of the carbon nano linear structures such as carbon nanotubes. In this manufacturing method, a transparent conductive layer can be formed by merely applying the carbon nanotube dispersion liquid, and high temperature or vacuum is unnecessary in the manufacturing process. Accordingly, even a support that is weak against heat, a support that is broken or modified in vacuum, or a support that is too large to fit into a vacuum container can be used as the support, and a transparent conductive layer can be formed on the surface thereof. As described above, if the method of manufacturing a capacitive touch member of the present invention is used, it is possible to provide a capacitive touch member on the surface of a support having a free shape without changing the shape.

### Brief Description of Drawings

[Figs. 1] A perspective view (a) and cross-sectional views (b) and (c) each showing a structure of a capacitive touch detection apparatus according to Embodiment 1 of the present invention.
[Figs. 2] Cross-sectional views each showing a structure of a capacitive touch detection apparatus according to another example of Embodiment 1 of the present invention.
[Figs. 3] A perspective view (a) and a cross-sectional view (b) each showing a structure of a capacitive touch detection apparatus according to still another example of Embodiment 1 of the present invention.
[Fig. 4] A perspective view showing examples of a stereoscopic shape of a light transmissive support according to Embodiment 1 of the present invention.
[Figs. 5] Cross-sectional views each showing a structure of a capacitive touch detection apparatus according to Embodiment 2 of the present invention.
[Fig. 6] A cross-sectional view showing a structure of a capacitive touch detection apparatus according to Embodiment 3 of the present invention.
[Fig. 7] A cross-sectional view showing a structure of a capacitive touch detection apparatus according to Embodiment 4 of the present invention.
[Figs. 8] Top views (left-side views) and side views (right-side views) showing examples of a division pattern of a capacitive touch member according to Embodiment 4 of the present invention.
[Figs. 9] A perspective view (a) showing a structure of a capacitive touch member and a cross-sectional view (b) in a horizontal direction according to another example of Embodiment 4 of the present invention.
[Figs. 10] Perspective views for explaining a method of using a capacitive touch member according to Embodiment 4 of the present invention.
[Figs. 11] A perspective view (a) showing a structure of a display apparatus equipped with a touch panel shown in Patent Document 1, and a cross-sectional view (b) showing a structure of a touch member.
[Figs. 12] A perspective view (a) and a cross-sectional view (b) each showing an arrangement example of a touch sensor shown in Patent Document 6.

### Modes for Carrying Out the Invention

In a first capacitive touch member of the present invention, it is preferable to coat the detection electrode with a coating layer.

In a fourth capacitive touch member of the present invention, it is preferable to provide an underlayer between the surface of the article and the light transmissive conductive layer.

In the first to fourth capacitive touch members of the present invention, it is preferable to provide the plurality of detection electrodes divided so as to partition positions on the touch surface together with lead-out wires that are independent for each of the electrodes, and to be capable of distinguishing a difference in touch position approached or contacted by the contact object on the touch surface in unit of the partition.

In the first to fourth capacitive touch members of the present invention, it is preferable for the light transmissive conductive layer to be formed of a complex of the carbon nano linear structure and a conductive resin material. Since the carbon nano linear structure is extremely thin and has a large surface area (specific surface area) per unit mass, an auxiliary material is not necessarily needed, but if needed, poly(3,4-ethylenedioxythiophene) (PEDOT; trade name Baytron) as a conductive polymer having high transparency or the like is preferable. Further, it is preferable for the carbon nano linear structure to be a carbon nanotube. A single-layer carbon nanotube includes a metallic carbon nanotube showing extremely high electrical conductivity. Further, some two-layer carbon nanotubes or multiplayer carbon nanotubes show extremely high electrical conductivity. In addition, unlike an oxide-based transparent conductive material such as ITO, a carbon nanotube has supple and strong mechanical characteristics.

In the first to third capacitive touch members of the present invention, there is a case where it is preferable for the support to be light transmissive in consideration of various applications. Similarly, there is a case where it is preferable for the protective film to be light transmissive. Examples of the cases include a case where the touch member is required to be light transmissive, like a touch panel in which the touch member is arranged in front of an image display apparatus.

Further, the stereoscopic shape of the support may be formed by one curved surface, a combination of curved surfaces, a combination of a curved surface and a flat surface, or a combination of flat surfaces. For example, it is preferable for the stereoscopic shape of the support to be a curved shape, and for an outer surface of a convex shape or an inner surface of a concave shape to be used as the touch surface. Further, it is possible to produce a capacitive touch member having the touch surface having a stereoscopically closed shape by connecting a plurality of touch surfaces.

It is preferable for the capacitive touch detection apparatus of the present invention to be used together with another electronic equipment and to be constituted as a touch switch that outputs an electrical signal to the other electronic equipment in accordance with the approach or contact of the contact object with respect to the touch surface. For example, it is preferable for the other electronic equipment to be an information processing apparatus and for the capacitive touch detection apparatus to be constituted as a touch panel that outputs an input signal corresponding to a touch position approached or contacted by the contact object on the touch surface to the information processing apparatus.

It is preferable for the method of manufacturing a capacitive touch member to include forming a protective film that coats the detection electrode and has a surface used as a touch surface.

Further, it is preferable for the dispersion liquid to be caused to adhere to the support by a coating method, a dipping method, or a printing method.

Next, preferred embodiments of the present invention will be described specifically with reference to the drawings.

### [Embodiment 1]

Hereinafter, a capacitive touch member, a capacitive touch detection apparatus, and a manufacturing method for the capacitive touch member according to Embodiment 1 of the present invention will be described. In this case, a carbon nanotube is used as the carbon nano linear structure.

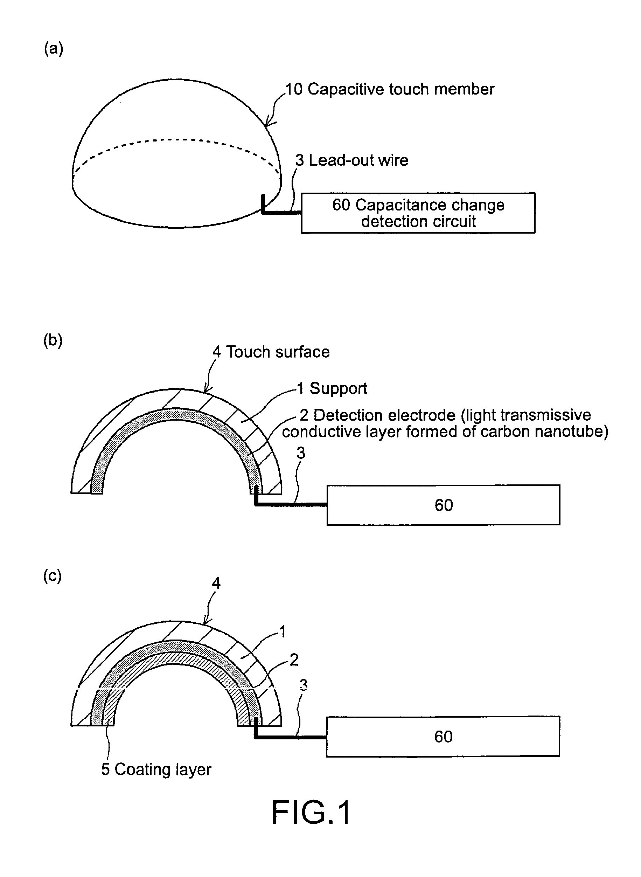

Fig. 1(a) is a perspective view showing a structure of a capacitive touch detection apparatus according to Embodiment 1. and Fig. 1(b) is a cross-sectional view thereof. The capacitive touch detection apparatus is constituted of a capacitive touch member 10 based on the first capacitive touch member of the present invention, and a capacitance change detection circuit 60.

The capacitive touch member 10 is constituted of a film-like or plate-like support 1 formed of an insulating material and having a stereoscopic shape, a detection electrode 2 that is formed of a light transmissive conductive layer containing a carbon nano linear structure and is arranged on at least a part of one surface of the support 1, and a lead-out wire 3 that is led out from the detection electrode 2.

In the capacitive touch member 10, the surface of the support 1 that is opposite to the surface on which the detection electrode 2 is arranged is used as a touch surface 4. In other words, when a contact object such as a part of a human body, e.g., a finger approaches or contacts the touch surface 4, a capacitance between the contact object and the detection electrode 2 is changed. This change in capacitance is transmitted to the capacitance change detection circuit 60 via the lead-out wire 3, converted into an electrical signal, and sensed. As the capacitance change detection circuit 60, a general capacitance measurement apparatus commercially available, for example, CapSense series (trade name) by Cypress Semiconductor Corporation, or the like can be used.

In the capacitive touch detection method, with the detection electrode 2 and an insulating (dielectric) material that separates the detection electrode 2 and the touch surface 4, a capacitive touch member can be configured with ease. As shown in Fig. 1(b), the support 1 formed of an insulating material and the detection electrode 2 formed of a transparent conductive layer formed thereon meet the configuration conditions, and can be used as the capacitive touch member 10. In this case, it is extremely important that a touch detection method be in a capacitive system. As described above, in the resistive touch panel, it is necessary to hold two base materials on which resistive films are formed with a slight gap therebetween, and a touch member cannot be formed so easily.

The material of the support 1 is not particularly limited except for being an insulating material. However, in the case where the touch member is arranged in front of an image display apparatus, the material of the support 1 has to be light transmissive. As the light transmissive support 1, a glass plate or a light transmissive polymer resin plate can be used. Examples of the material of the light transmissive polymer resin plate include a polyethylene terephthalate (PET) resin, a polycarbonate (PC) resin, a polymethylmethacrylate (PMMA) resin, a polypropylene (PP) resin, a polyethylene (PE) resin, a polyether sulfone (PES) resin, a polyimide (PI) resin, and an epoxy resin. Preferably, the material may have high transparency and be excellent in heat resistance and chemical resistance. Examples of such material include a PET.

Considering that the detection electrode 2 is provided on the surface opposite to the touch surface 4 and a capacitance is generated between a contact object that approaches or contacts the touch surface 4 and the detection electrode 2, it is important for the thickness of the support 1 to be not too large. Therefore, it is preferable for the support 1 to have a thickness of, for example, 0.01 to 3 mm, normally about 0.1 to 0.5 mm, and be flexible tape-like, film-like, or sheet-like. In this case, the support 1 can be used in a form of being attached to an article having an arbitrary stereoscopic shape. Further, as shown in Figs. 1, it is preferable for the film-like, sheet-like, or plate-like support 1 to be formed in, for example, a stereoscopic shape such as a hollow hemispherical shape. It is desirable for the shape to be partially opened to an extent that carbon nanotube dispersion liquid can flow in. In this way, a capacitive touch detection member can be provided without changing the shape thereof to the support 1 having a stereoscopic shape, while there are some limits on the shape.

The detection electrode 2 is formed of a light transmissive conductive layer containing a carbon nanotube. The type of carbon nanotube is not particularly limited. It is preferable for the carbon nanotube to be a single layer, have less impurities, high crystallinity of the carbon nanotube itself, and a thick diameter, and be as long as possible. The carbon nanotube has a diameter much smaller than a wavelength of visible light, and therefore causes visible light to pass therethroguh well. In addition, some carbon nanotubes have extremely high electrical conductivity like a metallic carbon nanotube, and indicate sufficient electrical conductivity at a small surface density. In addition, unlike an oxide-based transparent conductive material such as ITO, the carbon nanotube has supple and strong mechanical characteristics. Further, the carbon nanotube is chemically stable. As described above, the light transmissive conductive layer containing the carbon nanotube has the best characteristics as a detection electrode used for a touch member having a flexible shape or a stereoscopic shape.

The feature of the capacitive touch member and capacitive touch detection apparatus according to the present invention resides in that a practical touch detection apparatus having a flexible shape or a stereoscopic shape has been achieved for the first time by using a light transmissive conductive layer containing a carbon nanotube as a detection electrode and combining the light transmissive conductive layer with a capacitive touch detection method.

Of those, in Embodiment 1, the surface of the support 1 that is opposite to the detection electrode 2 is used as the touch surface 4. With this, the capacitive touch member 10 can be constituted in the simplest manner. Therefore, the capacitive touch member 10 can be produced at the lowest cost and good productivity.

Fig. 1(c) is a cross-sectional view showing an example of a capacitive touch member in which the detection electrode 2 is coated with a coating layer 5. The coating layer 5 improves the adherability of a carbon nanotube and also a light transmittance. The material constituting the coating layer 5 needs to have good optical characteristics (high transparency, low reflectiveness, low glare), easy formability, and electrical insulating properties. Further, a polymer material is preferable and it is known that the use of a polymer having a sulfone group -SO3H stabilizes the conductivity of the carbon nanotube (see Japanese Patent Application Laid-open No. 2008-251271). From the above, Nafion (registered trademark of Du Pont) is particularly suitable as the material constituting the coating layer 5, and in addition thereto, a polystyrene resin, a polymethylmethacrylate resin, a polyvinyl chloride resin, a polyvinylidene chloride resin, a polycarbonate resin, a silicone resin, a styrene-acrylonitrile copolymer (AS) resin, a TPX resin (crystalline olefin polymer mainly formed of 4-methyl pentene-1), or the like may be used. Examples of a method of forming the coating layer 5 include a method of dissolving a constituent material in an appropriate solvent and then applying a solution by a dipping method, a spraying method, or the like.

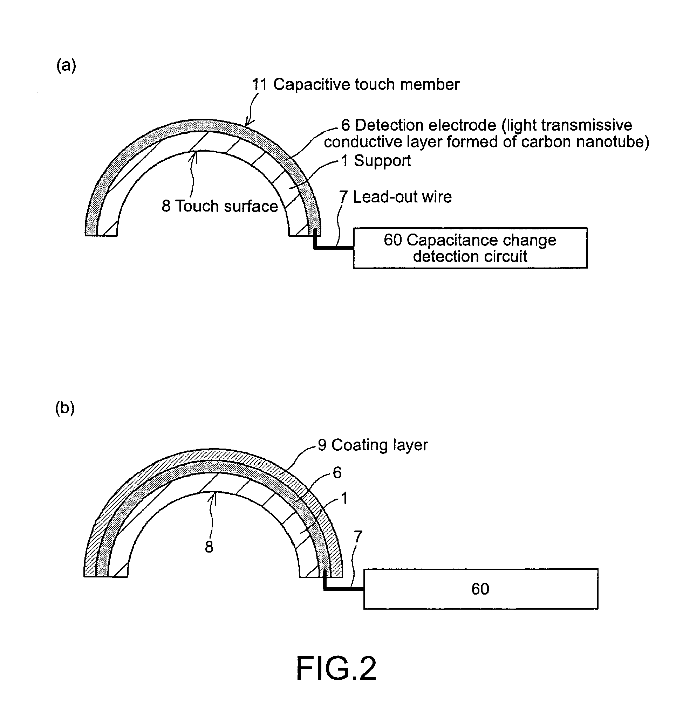

Fig. 2(a) is a cross-sectional view showing a structure of a capacitive touch detection apparatus according to another example of Embodiment 1. In the capacitive touch member 10 shown in Figs. 1, the detection electrode 2 is arranged on the inner surface (concave surface) of the hemispherical support 1 and the outer surface (convex surface) is used as the touch surface 4. On the other hand, in a capacitive touch member 11 shown in Fig. 2(a), a detection electrode 6 is arranged on the outer surface (convex surface) of the hemispherical support 1 and the inner surface (concave surface) is used as a touch surface 8. In this way, the surface on which the detection electrode is arranged differs and as a result the touch surface is reversed, which causes a large difference in use. However, there is no important difference therebetween in the mechanism of touch detection. Fig. 2(b) shows an example in which the detection electrode 6 is coated with a coating layer 9, similar to Fig. 1(c).

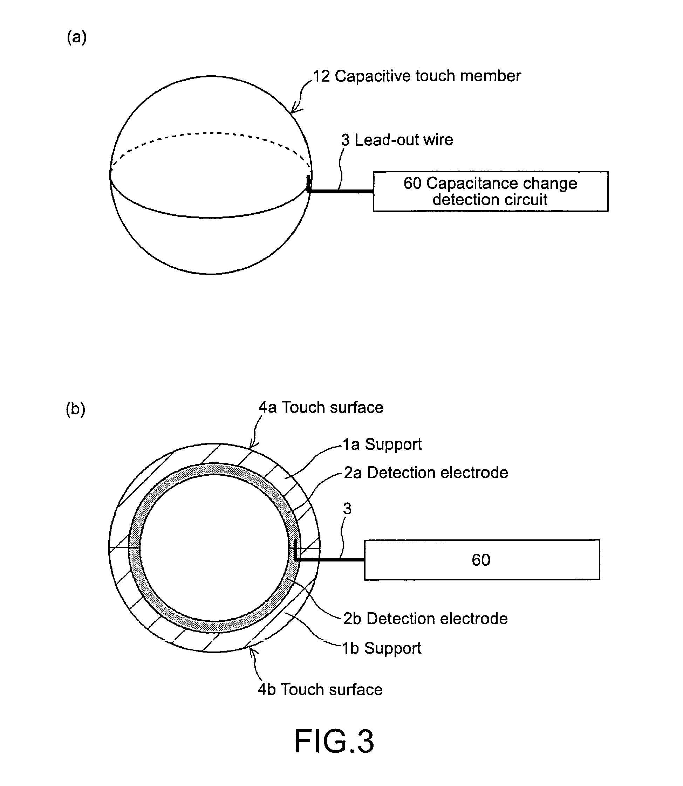

Figs. 3 are a perspective view (a) and a cross-sectional view (b) each showing a structure of a capacitive touch detection apparatus according to still another example of Embodiment 1. A capacitive touch member 12 shown in Figs. 3 is an example of a capacitive touch member having a closed spherical touch surface constituted of a touch surface 4a and a touch surface 4b, the capacitive touch member being produced by joining two hemispherical capacitive touch members 10, that is, a capacitive touch member 10a constituted of a hemispherical support 1a, a detection electrode 2a, and a lead-out wire 3a, and a capacitive touch member 10b similarly constituted of a hemispherical support 1b, a detection electrode 2b, and a lead-out wire 3b.

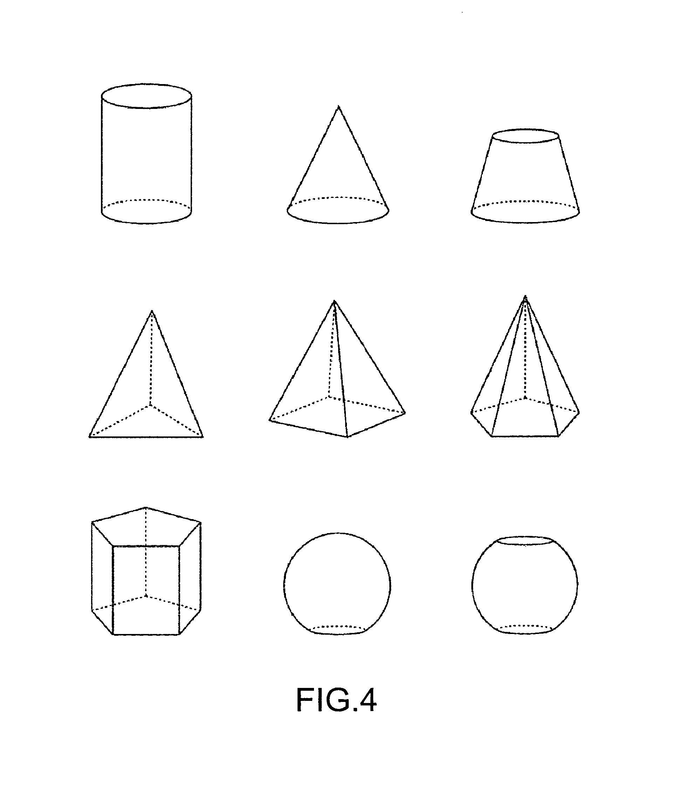

Fig. 4 is a perspective view showing examples of a stereoscopic shape of the light transmissive support. Those are various columns, cones, spheres, oval spheres, and the like, and the support may be a part of those solids or an arbitrary solid obtained by combining them. Generally, a stereoscopic shape of the support may be an arbitrary stereoscopic shape formed by one curved surface, a combination of curved surfaces, a combination of a curved surface and a flat surface, or a combination of flat surfaces. In this embodiment, a capacitive touch detection member can be formed on each of those supports without changing the shape thereof.

In the capacitive touch detection member having a flexible shape or a stereoscopic shape, the change in its shape can generate usefulness or a feeling that cannot be generated in a member whose shape is not changed. For example, when a capacitive touch detection member is produced with use of a support having a flexible stereoscopic shape, it can be used as an input apparatus that is dented or bent when touched, which can be used as a nonconventional interface.

Further, in the capacitive touch detection member having a stereoscopic shape, touch detection sensitivity can be improved as compared to a case of a flat shape. In a stereoscopic detection electrode, since both a front surface and a back surface of the detection electrode can be air layers, it is possible to reduce noise derived from a back substrate, which is problematic in a conventional flat-type capacitive touch detection apparatus, or malfunction or reduction in sensitivity due to a parasitic capacitance with a ground surface, or the like. Accordingly, in the capacitive touch detection apparatus having a stereoscopic shape, the sensitivity/accuracy of touch detection is significantly improved.

The capacitive touch detection apparatus according to the present invention can be a capacitive touch detection apparatus while maintaining the pattern or texture of the support 1. Further, the capacitive touch detection member can be produced with use of the light transmissive support, and in the case of being used for coating another article, the outer appearance or design of the article is utilized as it is to thereby obtain a capacitive touch detection member.

In addition to the above, a stereoscopic capacitive touch detection apparatus having a carbon nanotube as a conductive layer has a high degree of freedom in shape and can be provided with light transparency. Therefore, since the stereoscopic capacitive touch detection apparatus does not have any influence on operations even when provided on a display, a light-emitting element, a photoelectric conversion element, or the like, the stereoscopic capacitive touch detection apparatus can be developed into electronics equipment combined with them.

Hereinafter, a manufacturing method for the capacitive touch member 10 will mainly been described, and the description on the capacitive touch member 10 will be added.

First, dispersion liquid obtained by dispersing carbon nanotubes in a dispersion solvent containing a dispersing agent is prepared. Water is preferable for the dispersion solvent, and a surface-active agent is preferable for the dispersing agent. Carbon nanotubes are added to water in which the surface-active agent is dissolved, mixed with ultrasonic waves being applied thereto, and dispersed uniformly. After that, sediments having low dispersibility are removed by a centrifugation method.

The concentration of carbon nanotubes in the dispersion liquid is preferably set to 0.1 to 0.5 mg/mL with 0.2 mg/mL as the center. A lower concentration of carbon nanotubes allows a deposition layer having high uniformity to be formed, which enables a conductive layer having uniform conductivity to be obtained. However, if the concentration is too low, the number of repetitions of a deposition process of carbon nanotubes that will be described later becomes too many until sufficient conductivity is obtained. If the concentration of carbon nanotubes is too high, the number of repetitions of the deposition process is reduced but the conductivity is prone to vary.

Regarding the type of surface-active agent, sodium alkyl sulfate, sodium linear alkylbenzene sulfonate, sodium alpha-olefin sulfonate, sodium alkyl ether sulfate, fatty acid alkanolamide, alkylamine oxide, or the like can be used, and a combination thereof can be used. The concentration of the surface-active agent preferably falls within the range of 0.1 to 4% with 0.4% as the center. If the concentration of the surface-active agent is extremely low, the dispersibility of carbon nanotubes is insufficient, which causes the lowering of transparency and conductivity. If the concentration of the surface-active agent is too high, the adhesiveness between the carbon nanotubes and the surface of the support 1 (surface of an article in Embodiment 5 to be described later) is lowered, and an inconvenience that almost all of the deposited carbon nanotubes are peeled off by water washing is caused.

Next, to one surface of the support 1 that is formed of an insulating material such as a PET film, formed in advance, and has a stereoscopic shape (surface of an article in Embodiment 5), the dispersion liquid is caused to adhere by a coating method, a dipping method, or a printing method. For example, in the case of the capacitive touch member 10, the dispersion liquid is poured into the hemispherical support 1 on the concave surface side and spread over the surface. When excess carbon nanotube dispersion liquid is drained, the entire concave surface of the support 1 is wet by the carbon nanotube dispersion liquid.

Next, the dispersion solvent is evaporated and the carbon nanotubes are firmly fixed to the surface of the support 1 (surface of an article in Embodiment 5). In this case, a dryer is preferably used for drying by heating with hot air. It is preferable to perform evaporation until the whole is sufficiently dried. A time required up to the completion of the evaporation is about 30 seconds. A higher temperature of the hot air is preferable because a time required for drying is shortened. However, in the case where the support 1 is formed of plastic, there is a fear that the support 1 is deformed when the temperature is too high. Therefore, the temperature is preferably set to around 100°C. In this case, it is preferable to perform drying while constantly moving the support 1 so as to prevent the thickness of the dispersion liquid from being unbalanced and the carbon nanotubes from being concentrated at one part and dried.

Next, as the feature of the manufacturing method in the present invention, the surface of the support 1 on which the carbon nanotubes are deposited (surface of an article in Embodiment 5) is washed by a washing solvent, the dispersing agent is removed, and then the washing solvent is evaporated. For example, in the case of the capacitive touch member 10, the support 1 is immersed in water and the remaining dispersing agent is washed off. After this process is repeated several times, hot air is used for completely drying the support 1. Since the dispersing agent interposed between the carbon nanotubes is removed in the washing process using the washing solvent, the adhesiveness between the carbon nanotubes is improved and the conductivity is improved. Slowly running water or accumulation water is preferable for the washing solvent. A time required for immersion in water is preferably about five seconds, and the number of washing is preferably about three. Since most carbon nanotubes are firmly fixed to the surface of the support 1 (surface of an article in Embodiment 5) in the previous process of evaporating the dispersion solvent, those carbon nanotubes do not fall off in this process. Further, a small number of carbon nanotubes in the poor fixed state are removed in the washing process. The remaining carbon nanotubes are more firmly fixed to the surface of the support 1 (surface of an article in Embodiment 5) in the process of evaporating the washing solvent. As described above, the quality of the carbon nanotube deposition layer is improved.

The series of processes described above from the adhesion of the dispersion liquid to the evaporation of the washing solvent is repeatedly performed until the deposition layer of carbon nanotubes reaches a predetermined thickness and necessary conductivity is obtained, to thereby laminate carbon nanotube layers. In this way, a light transmissive conductive layer containing carbon nanotubes is formed on the surface of the support 1 (surface of an article in Embodiment 5). As described above, the concentration of carbon nanotubes in the dispersion liquid can be suppressed to be low as compared to a method of forming a deposition layer having a predetermined thickness by a single deposition process. As a result, a deposition layer having high uniformity can be formed and a conductive layer having uniform conductivity can be obtained.

As described above, in the manufacturing method for the capacitive touch member according to this embodiment, it is possible to form a deposition layer having a small amount of dispersing agent or impurities, having uniform distribution of carbon nanotubes, and having high flatness by a simple and easily scaled-up method, and to produce a light transmissive conductive layer capable of being expressed without impairing the light transparency, electrical conductivity characteristics, and mechanical characteristics of the carbon nanotubes. In this manufacturing method, a light transmissive conductive layer can be formed by merely applying the carbon nanotube dispersion liquid, and it is unnecessary to expose the support to high temperature or vacuum in the manufacturing process. Accordingly, a light transmissive conductive layer can be formed even on the surface of a support that is weak against heat (article in Embodiment 5), a support that is broken or modified in vacuum, or a support that is too large to be fit into a vacuum container (article in Embodiment 5).

After that, if necessary, polymer dispersion liquid or the like is applied to the detection electrode 2 and then the solvent is evaporated, to thereby form the coating layer 5.

Next, the lead-out wire 3 is provided to the detection electrode 2. For example, the lead-out wire 3 is bonded to the detection electrode 2 with use of a conductive adhesive.

In addition to the above processes, a process of forming a protective film on a detection electrode is performed in Embodiments 2, 3, and 5 to be described later. Further, in Embodiment 4 to be described later, a process of etching a part of the light transmissive conductive layer for removal and patterning the light transmissive conductive layer into a plurality of divided detection electrodes 42a to 42f is performed. Further, the patterning into the detection electrodes 42a to 42f may be performed by a lift-off method of coating in advance with a mask layer the surface of the support 1 other than an area in which the detection electrodes 42a to 42f are formed, forming the light transmissive conductive layer over the entire surface of the support 1, and then dissolving a light transmissive conductive layer deposited in the area other than the detection electrodes 42a to 42f for removal together with the mask layer. Further, the patterning into the detection electrodes 42a to 42f may be performed by a printing method of causing the carbon nanotube dispersion liquid to adhere to only the area in which the detection electrodes 42a to 42f are formed.

In the manufacturing method for the capacitive touch member in this embodiment, a detection electrode formed of a light transmissive conductive layer can also be formed on the surface of a support having any shape as long as the support has a partially opened shape, with the result that a capacitive touch member can be produced. The capacitive touch member produced as described above can be formed into a stereoscopic shape adjusted to the shape of an apparatus to which the touch detection apparatus is to be provided. Therefore, the capacitive touch member can also be provided to an apparatus to which a touch detection apparatus cannot be provided conventionally, and the apparatus can be used as a touch detection apparatus having a touch panel of a new type with high design and high fashion. Further, according to a printing method, since the carbon nanotube dispersion liquid is caused to adhere to only the area in which the detection electrodes are formed, the patterned detection electrodes can be obtained without performing an etching process, the manufacturing process is simplified to a large extent, and low costs can be achieved.

### [Embodiment 2]

Hereinafter, a capacitive touch member according to Embodiment 2 of the present invention will be described.

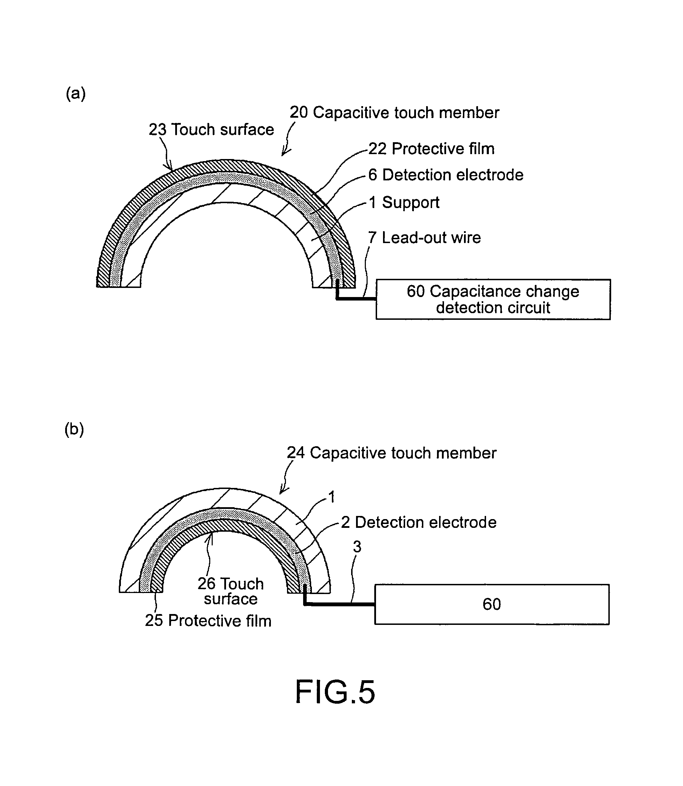

Figs. 5 are cross-sectional views each showing a structure of a capacitive touch detection apparatus according to Embodiment 2. The capacitive touch detection apparatus is constituted of a capacitive touch member 20 based on the second capacitive touch member of the present invention, and a capacitance change detection circuit 60.

In the capacitive touch member 20 shown in Fig. 5(a), a detection electrode 6 is arranged on the outer surface of a hemispherical support 1 (convex surface), and a protective film 22 that coats the detection electrode 6 is laminated thereon so that the surface of the protective film 22 is used as a touch surface 23. Further, a capacitive touch member 24 shown in Fig. 5(b), a detection electrode 2 is arranged on the inner surface of the hemispherical support 1 (concave surface), and a protective film 25 that coats the detection electrode 2 is laminated thereon so that the surface of the protective film 25 is used as a touch surface 26.

As described above, in Embodiment 2, the surface 4 of the support 1 that is opposite to the detection electrode 2 is not used as a touch surface, and the surface of the protective film 22 (or 25) arranged by being laminated on the detection electrode 6 (or 2) is used as the touch surface 23 (or 26), which is different from Embodiment 1. The protective film 22 (or 25) is required for adhesiveness by which peel-off is not caused by contact of a finger or the like, or antifouling property by which a fingerprint or soil is difficult to adhere. Therefore, the protective film 22 (or 25) has to be excellent in mechanical and chemical resistance in addition to the characteristics required for the coating layer 5 (or 9) described above. Further, it is preferable for a thickness to be as thin as possible because the touch detection sensitivity is raised. A constituent material and a production method for the protective film 22 (or 25) are in conformity with the constituent material and the production method for the coating layer 5 (or 9) described above.

With this, the limitation that the shape of the support 1 has a thickness not too large and has a tape-like, film-like, sheet-like, or plate-like shape, which is described in Embodiment 1, becomes invalid and the support 1 used in Embodiment 2 may have an arbitrary shape. Further, according to the present invention, it is possible to form the detection electrode 6 (or 2) on the surface of a support having any shape and to provide a capacitive touch detection apparatus. Further, since the thickness of the protective film 22 (or 25) can be reduced as compared to that of the support 1, a capacitance between the contact object and the detection electrode 6 (or 2) is increased and the sensitivity to detect a touch of the contact object is improved. Since Embodiment 2 is the same as Embodiment 1 except for the difference described above, description thereof will be omitted so as to avoid overlaps.

### [Embodiment 3]

Hereinafter, a capacitive touch member according to Embodiment 3 of the present invention will be described.

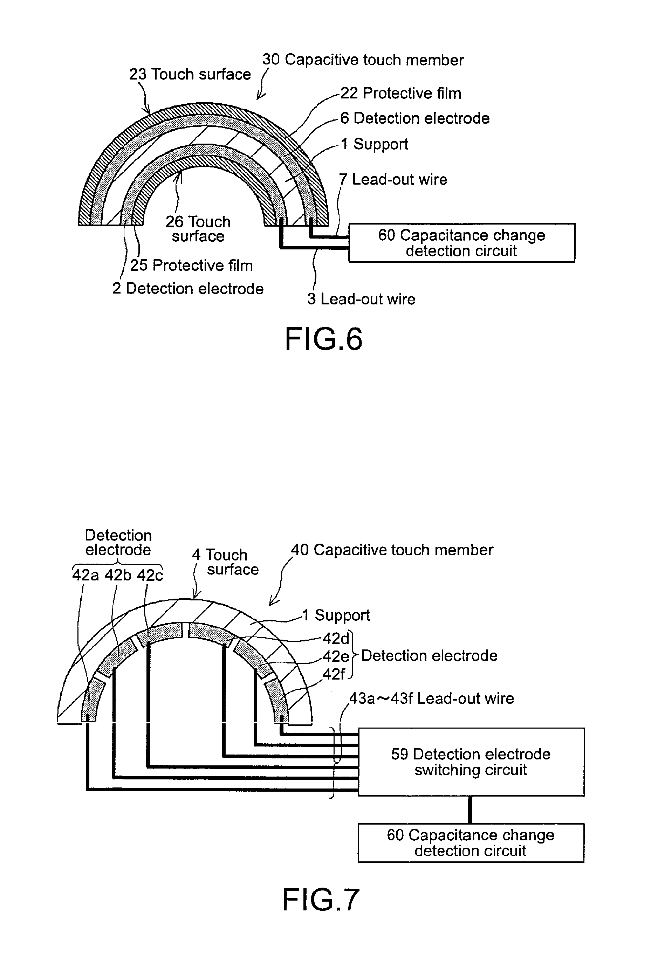

Fig. 6 is a cross-sectional view showing a structure of a capacitive touch detection apparatus according to Embodiment 3. The capacitive touch detection apparatus is constituted of a capacitive touch member 30 based on the third capacitive touch member of the present invention, and a capacitance change detection circuit 60.

In the capacitive touch member 30 shown in Fig. 6, a detection electrode 6 is arranged on the outer surface of a hemispherical support 1 (convex surface), and a protective film 22 that coats the detection electrode 6 is laminated thereon so that the surface of the protective film 22 is used as a touch surface 23. In addition, a detection electrode 2 is also arranged on the inner surface of the hemispherical support 1 (concave surface), and a protective film 25 that coats the detection electrode 2 is laminated thereon so that the surface of the protective film 25 is used as a touch surface 26. Here, the detection electrode 6 and the detection electrode 2 correspond to the first detection electrode and the second detection electrode, respectively, and the protective film 22 and the protective film 25 correspond to the first protective film and the second protective film, respectively. Lead-out wires 7 and 3 that are led out from the detection electrodes 6 and 2 are connected to input terminals of the capacitance change detection circuit 60.

In the capacitive touch member 30, both the detection electrode 6 and the detection electrode 2 can be used as detection electrodes, and both the touch surface 23 and the touch surface 26 can be used as touch surfaces at the same time. Alternatively, one detection electrode, for example, only the detection electrode 6 can be used as a detection electrode, and the detection electrode 2 can be grounded so as to improve noise immunity characteristics. The capacitance change detection circuit 60 can easily switch between the detection electrode 6 and the detection electrode 2 to be used as a detection electrode and accordingly between the touch surface 23 and the touch surface 26 to be used as a touch surface. Since Embodiment 3 is the same as Embodiment 2 except for the difference described above, description thereof will be omitted so as to avoid overlaps.

### [Embodiment 4]

Hereinafter, a capacitive touch member and a capacitive touch detection apparatus according to Embodiment 4 of the present invention will be described.

Fig. 7 is a cross-sectional view showing a structure of a capacitive touch detection apparatus according to Embodiment 4. The capacitive touch detection apparatus is constituted of a capacitive touch member 40 and a capacitance change detection circuit 60.

The capacitive touch member 40 is constituted of a film-like or plate-like support 1 formed of an insulating material and having a stereoscopic shape, a detection electrode 42 that is formed of a light transmissive conductive layer containing a carbon nano linear structure and is arranged on at least a part of one surface of the support 1, and a lead-out wire 43 that is led out from the detection electrode 42.

The difference from Embodiment 1 resides in that a plurality of detection electrodes 42a to 42f divided so as to partition positions on the touch surface 4 are provided in accordance with differences of touch positions approached or contacted by a contact object, together with lead-out wires 43a to 43f that are independent for each of the electrodes, and a difference in touch position can be distinguished in unit of the partition. The detection electrodes 42a to 42f are repeatedly selected by time-sharing by a detection electrode switching circuit 59. In other words, the detection electrodes 42a to 42f are alternately connected to the capacitance change detection circuit 60 only for a certain time period in one cycle, and this cycle is repeated at high speed in a short period.

For example, when a contact object such as a part of a human body, e.g., a finger approaches or contacts a position of the touch surface 4 that is opposite to the detection electrode 42a, a capacitance between the contact object and the detection electrode 42a is changed. This change in capacitance is transmitted to the capacitance change detection circuit 60 via the lead-out wire 43a, converted into an electrical signal, and sensed.

The carbon nanotube layer constituting the detection electrodes 42a to 42f of the capacitive touch member 40 can be patterned by removing unnecessary portions by performing etching after film formation or masking a part of the surface of the support 1 before film formation, as additionally described in Embodiment 1. Alternatively, a printing method may be used. Etching can be performed by, for example, mechanical cutting removal or laser etching.

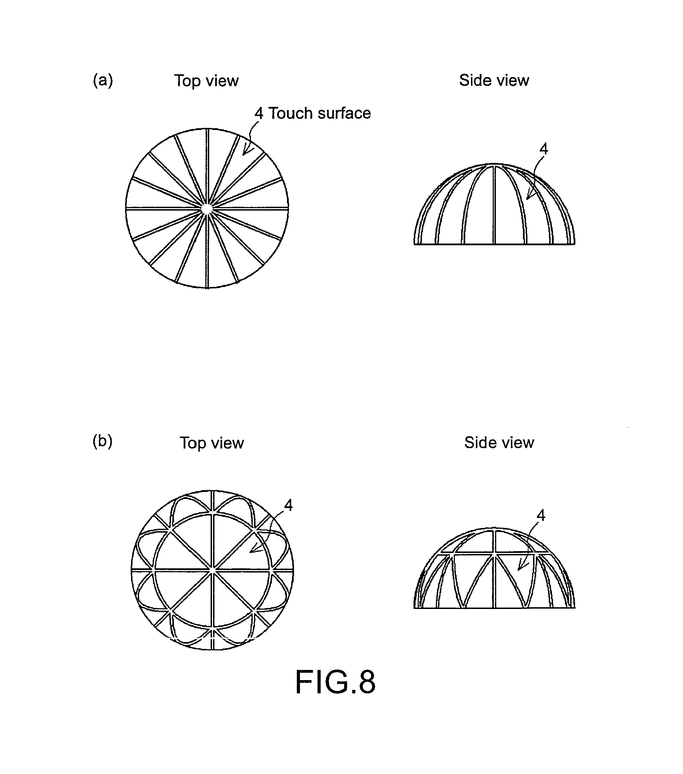

Figs. 8 are top views (left-side views) and side views (right-side views) showing division patterns of the capacitive touch member 40. A pattern shown in Fig. 8(a) is divided by longitudes, and the difference in touch position on a hemisphere surface can be determined based on the difference in degree of longitude. A pattern shown in Fig. 8(b) is divided more intricately, and the difference in touch position on a hemisphere surface can be determined in more details, in addition to the difference in degree of latitude. Further, the transparent conductive layer formed on a support having an arbitrary stereoscopic shape as shown in Fig. 4 can also be patterned similarly to Fig. 7 or Figs. 8.

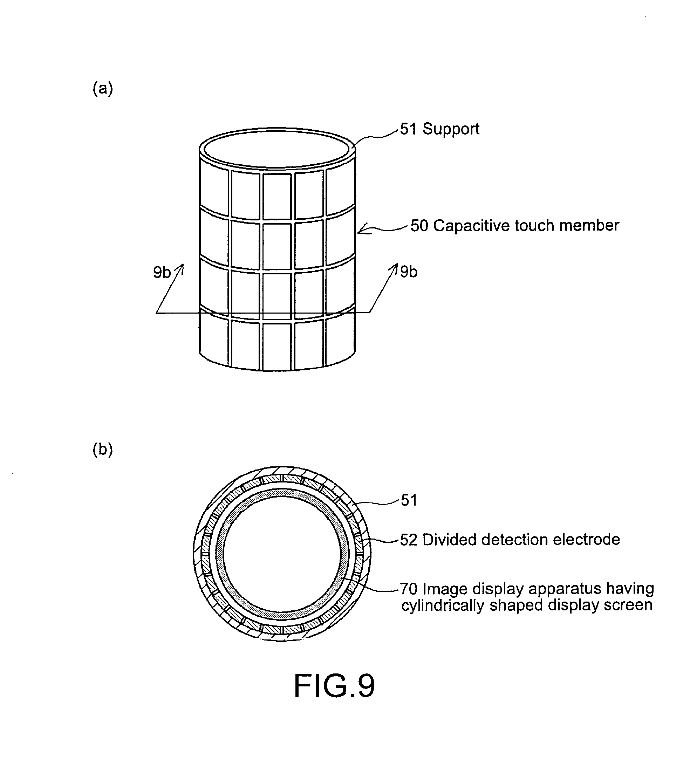

Fig. 9(a) is a perspective view showing a division pattern of a capacitive touch member 50 according to another example of Embodiment 4. Fig. 9(b) is a cross-sectional view in a horizontal direction indicated by the line 9b-9b shown in Fig. 9(a). In the capacitive touch member 50, many divided detection electrodes 52 are arranged on the inner wall of a cylindrically shaped support 51. Fig. 9(b) shows a state where an image display apparatus 70 having a cylindrically shaped display screen is accommodated inside.

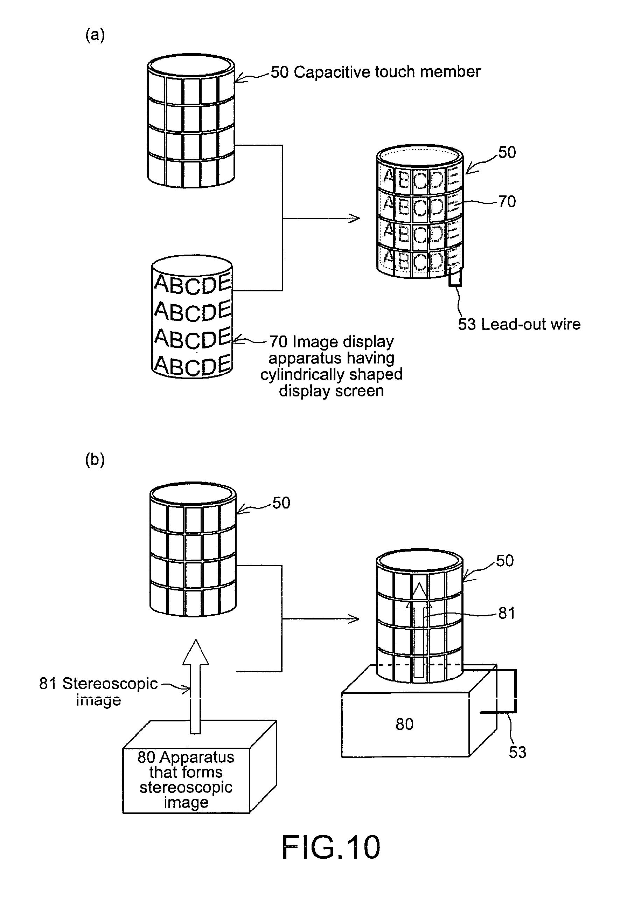

Figs. 10 are perspective views for explaining a method of using the capacitive touch member 50. In an example shown in Fig. 10(a), the capacitive touch member 50 is arranged on the outermost surface of the image display apparatus 70 having the cylindrically shaped display screen, and a communication means using a lead-out wire 53 is provided therebetween. As a result, since the cylindrically shaped display screen of the image display apparatus 70 can be seen through the touch surface of the capacitive touch member 50, the image display apparatus 70 can be operated intuitively by a touch to the touch surface while an image is being seen. The example of the image display apparatus 70 having the cylindrically shaped display screen is shown in the Press Release of Sony Corporation on May 24, 2007, http://www.sony.co.jp/SonyInfo/News/Press/200705/07-053/index.html, or the like.

In the example shown in Fig. 10(b), the capacitive touch member 50 is arranged on the top of an image forming apparatus 80 that forms a three-dimensional stereoscopic image 81 upwardly, and a communication means using a lead-out wire 53 is provided therebetween. As a result, since the three-dimensional stereoscopic image 81 formed by the image forming apparatus 80 can be seen through the touch surface of the capacitive touch member 50, the image forming apparatus 80 can be operated intuitively by a touch to the touch surface while the stereoscopic image 81 is being seen. The example of the image forming apparatus 80 that forms the three-dimensional stereoscopic image 81 is shown in the News Release of Hitachi, LTD. on February 24, 2004, http://www.hitachi.co.jp/New/cnews/040224a.html, the Press Release of The National Institute of Advanced Industrial Science and Technology on July 10, 2007, http://www.aist.go.jp/aist_j/press_release/pr2007/pr20070710/p r20070710.html, or the like.

### [Embodiment 5]

Hereinafter, the fourth capacitive touch member according to Embodiment 5 of the present invention will be described. Though not shown in the figure, a capacitive touch detection apparatus according to Embodiment 5 is constituted of a fourth capacitive touch member including a detection electrode that is formed of a light transmissive conductive layer containing a carbon nano linear structure and is arranged on at least a part of the surface of an article to which a touch detection function is intended to be imparted, a light transmissive protective film that coats the detection electrode, and a lead-out wire that is led out from the detection electrode, and a capacitance change detection circuit 60. In the capacitive touch member, the surface of the light transmissive protective film is used as a touch surface, and approach or contact of a contact object such as a part of a human body, e.g., a finger with respect to the touch surface is sensed as a change in capacitance between the contact object and the detection electrode.

The article to which the capacitive touch member is provided is preferably an article capable of being provided with a light transmissive conductive layer containing the carbon nano linear structure, and is not particularly limited. For example, the doll-shaped toy 210 shown in Patent Document 2 or the like may be possible, or a casing of electronic equipment such as PDA (personal digital assistant), a mobile phone, a laptop personal computer, a portable game device, or a video camera, the casing having a curved surface shape, may be particularly possible. Further, furniture such as a knob of a door or daily necessaries may also be possible. Since the capacitive touch member is thin and light transmissive, the capacitive touch member can be provided to an article without imparting the outer appearance of the article.

Heretofore, the present invention has been described according to the embodiments, but the present invention is not limited to those examples and can be modified as appropriate without departing from the gist of the present invention.

### Industrial Applicability

According to the present invention, it is anticipated that the degree of freedom in shape of a capacitive touch detection apparatus such as a touch panel and productivity are dramatically improved and an available product range is widened to a great extent.

### Description of Symbols

- 1,1a,1b: support

- 2,2a,2b,6: detection electrode (light transmissive conductive layer containing carbon nanotube)
- 3,7: lead-out wire
- 4,4a,4b,8: touch surface
- 5,9: coating layer
- 10 to 12: capacitive touch member
- 20,24: capacitive touch member
- 22,25: protective film
- 23,26: touch surface
- 30: capacitive touch member
- 40: capacitive touch member
- 42a to 42f: detection electrode
- 43a to 43f: lead-out wire
- 50: capacitive touch member
- 51: support
- 52: divided detection electrode
- 53: lead-out wire
- 59: detection electrode switching circuit
- 60: capacitance change detection circuit
- 70: image display apparatus including cylindrically shaped display screen
- 80: image forming apparatus to form three- dimensional stereoscopic image
- 81: three-dimensional stereoscopic image
- 100: display apparatus with touch panel
- 101: light-emitting diode (LED)
- 102: liquid crystal panel
- 103: curved touch panel
- 110: touch member
- 111: curved substrate
- 112: transparent conductive film
- 113: protective film
- 114: touch surface
- 200: capacitive touch sensor
- 201: base material
- 201a: electrode portion
- 201b: extension portion
- 202: detection electrode
- 203: detection circuit unit
- 211: casing
- 210: doll-shaped toy
- 212: concave portion

## Claims

1. A capacitive touch member, comprising:
a film-like or plate-like support that is formed of an insulating material and has a flexible shape or a stereoscopic shape;
a detection electrode that is arranged on at least a part of one surface of the support and is formed of a light transmissive conductive layer containing a carbon nano linear structure; and
a lead-out wire that is led out from the detection electrode, wherein
a surface of the support that is opposite to the surface on which the detection electrode is arranged is used as a touch surface, and approach or contact of a contact object with respect to the touch surface is sensed as a change in capacitance between the contact object and the detection electrode.

2. The capacitive touch member according to claim 1, wherein the detection electrode is coated with a coating layer.

3. A capacitive touch member, comprising:
a film-like or plate-like support that is formed of an insulating material and has a flexible shape or a stereoscopic shape;
a detection electrode that is arranged on at least a part of one surface of the support and is formed of a light transmissive conductive layer containing a carbon nano linear structure;
a protective film to coat the detection electrode; and
a lead-out wire that is led out from the detection electrode, wherein
a surface of the protective film is used as a touch surface, and approach or contact of a contact object with respect to the touch surface is sensed as a change in capacitance between the contact object and the detection electrode.

4. A capacitive touch member, comprising:
a film-like or plate-like support that is formed of an insulating material and has a flexible shape or a stereoscopic shape;
a first detection electrode that is arranged on at least a part of one surface of the support and is formed of a light transmissive conductive layer containing a carbon nano linear structure;
a first protective film to coat the detection electrode;
a second detection electrode that is arranged on at least a part of a surface opposite to the surface of the support and is formed of a light transmissive conductive layer containing a carbon nano linear structure;
a second protective film to coat the detection electrode; and
lead-out wires that are led out from the first detection electrode and the second detection electrode, wherein
a surface of the first protective film and/or the second protective film is used as a touch surface, and approach or contact of a contact object with respect to the touch surface is sensed as a change in capacitance between the contact object and the first detection electrode and/or the second detection electrode.

5. A capacitive touch member, comprising:
a detection electrode that is arranged on at least a part of a surface of an article and is formed of a light transmissive conductive layer containing a carbon nano linear structure;
a protective film to coat the detection electrode; and
a lead-out wire that is led out from the detection electrode, wherein
a surface of the protective film is used as a touch surface, and approach or contact of a contact object with respect to the touch surface is sensed as a change in capacitance between the contact object and the detection electrode.

6. The capacitive touch member according to claim 5, which is provided with an underlayer between the surface of the article and the light transmissive conductive layer.

7. The capacitive touch member according to any one of claims 1 to 6, wherein
the plurality of detection electrodes divided so as to partition a position on the touch surface are provided together with lead-out wires that are independent for each of the electrodes, and a difference in touch position approached or contacted by the contact object on the touch surface can be distinguished in unit of the partition.

8. The capacitive touch member according to any one of claims 1 to 6, wherein
the light transmissive conductive layer is formed of a complex of the carbon nano linear structure and a conductive resin material.

9. The capacitive touch member according to any one of claims 1 to 6, wherein
the carbon nano linear structure is a carbon nanotube.

10. The capacitive touch member according to any one of claims 1 to 4, wherein
the support is light transmissive.

11. The capacitive touch member according to any one of claims 3 to 6, wherein
the protective film is light transmissive.

12. The capacitive touch member according to any one of claims 1 to 4, wherein
the stereoscopic shape of the support is formed by one curved surface, a combination of curved surfaces, a combination of a curved surface and a flat surface, or a combination of flat surfaces.

13. The capacitive touch member according to claim 12, wherein
the stereoscopic shape of the support is a curved shape, and an outer surface of a convex shape or an inner surface of a concave surface is used as the touch surface.

14. The capacitive touch member according to claim 12, which has the touch surface having a stereoscopically closed shape.

15. A capacitive touch detection apparatus, comprising:
the capacitive touch member according to any one of claims 1 to 14;
a detection circuit unit that is electrically connected to the detection electrode via the lead-out wire and detects the change in capacitance due to the approach or contact of the contact object with respect to the touch surface.

16. The capacitive touch detection apparatus according to claim 15, which is used together with another electronic equipment and is constituted as a touch switch that outputs an electrical signal to the other electronic equipment in accordance with the approach or contact of the contact object with respect to the touch surface.

17. The capacitive touch detection apparatus according to claim 16, wherein
the other electronic equipment is an information processing apparatus, and
the capacitive touch detection apparatus is constituted as a touch panel that outputs an input signal corresponding to a touch position approached or contacted by the contact object on the touch surface to the information processing apparatus.

18. A method of manufacturing a capacitive touch member, comprising:
preparing dispersion liquid obtained by dispersing carbon nano linear structures in a dispersion solvent containing a dispersing agent;
performing at predetermined times a series of steps of
causing the dispersion liquid to adhere to a surface of a film-like or plate-like support that is formed of an insulating material and has a flexible shape or a stereoscopic shape, or to a surface of an article to which a touch member is provided,
evaporating the dispersion solvent and firmly fixing the carbon nano linear structures to the surface of the support or the surface of the article,
washing the surface of the support or the surface of the article by a washing solvent and removing the dispersing agent, and
evaporating the washing solvent, and
forming a detection electrode formed of a light transmissive conductive layer containing the carbon nano linear structures on the surface of the support or the surface of the article; and
providing a lead-out wire to the detection electrode.

19. The method of manufacturing a capacitive touch member according to claim 18, which includes forming a protective film that coats the detection electrode and has a surface used as a touch surface.

20. The method of manufacturing a capacitive touch member according to claim 18, wherein
the dispersion liquid is caused to adhere to the support by a coating method, a dipping method, or a printing method.
